# EUROPÄISCHE PATENTSCHRIFT

(11) **EP 1 615 484 B1**
(45) Veröffentlichungstag und Bekanntmachung des Hinweises auf die Patenterteilung: **18.02.2015**
(21) Anmeldenummer: 05013472.5
(22) Anmeldetag: 22.06.2005
(51) Int. Cl.: H05K 3/28, C09D 5/24

(54) **Artikel mit einer Beschichtung von elektrisch leitfähigem Polymer und Verfahren zu deren Herstellung**
Article with a coating of an electrically conductive polymer and process for making it
Article avec une couche d'un polymère électroconducteur et procédé de sa production

(30) Priorität: 23.06.2004 DE 102004030388
(43) Veröffentlichungstag der Anmeldung: 11.01.2006
(73) Patentinhaber: Enthone, Inc., West Haven, CT 06516 (US)
(72) Erfinder: Wessling, Bernhard, Dr., 22941 Bargteheide (DE)
(74) Vertreter: UEXKÜLL & STOLBERG

(56) Entgegenhaltungen:
- WO-A-95/00678
- WO-A-99/05687
- DE-C1- 19 525 708
- US-A- 5 922 466
- US-A1- 2004 060 729
- BRUSIC VLASTA ET AL: "Use of polyaniline and its derivatives in corrosion protection of copper and silver" J ELECTROCHEM SOC; JOURNAL OF THE ELECTROCHEMICAL SOCIETY FEB 1997, Bd. 144, Nr. 2, Februar 1997 (1997-02), Seiten 436-442, XP009054578
- PARQUET D T ET AL: "ALTERNATIVES TO HASL: A USER'S GUIDE FOR SURFACE FINISHES" ELECTRONIC PACKAGING AND PRODUCTION, CAHNERS PUBLISHING CO, NEWTON, MASSACHUSETTS, US, Bd. 35, Nr. 9, 1. August 1995 (1995-08-01), Seiten 38-42, XP000524919 ISSN: 0013-4945

## Beschreibung

Die vorliegende Erfindung betrifft beschichtete Artikel, die eine Schicht aus Kupfer oder einer Kupferlegierung und eine Schicht eines elektrisch leitfähigen Polymers zusammen mit bestimmten Kupfer-Komplexbildnern enthalten und die sich insbesondere als Leiterplatten oder zur Herstellung von Leiterplatten eignen.

Kupfer ist eines der am weitesten verbreiteten metallischen Werkstoffe unserer Zeit. Obwohl Kupfer ein Halbedelmetall ist, ist dieser Werkstoff leicht oxidierbar, was sich oftmals negativ auf seine Gebrauchseigenschaften auswirkt. Dies äußert sich nicht nur optisch, sondern hat insbesondere praktische technische Nachteile. Besondere Probleme treten bei der Beschichtung von Leiterplatten, die anschließend in Lötprozessen bestückt werden, Kupferdrähten, die als elektrische Leiter verwendet werden, oder Kupferrohren auf. Feinteilige Kupferpulver können praktisch nicht ohne Oxidationsschutz hergestellt und verwendet werden.

Kupfer wird normalerweise nicht wie Eisen und Stahl mit Schutzüberzügen versehen, die im Fall von Lacken häufig in mehreren Schichten aufgetragen werden müssen. Vielmehr werden als Schutz gegen Kupferkorrosion überwiegend Stoffe eingesetzt, die mit dem Kupfer Komplexe bilden, wie beispielsweise Imidazole, Benzimidazole, Benzotriazole, Thioharnstoff und Imidazol-2-thion.

Derartige organische Komplexbildner sind zwar preiswert und einfach zu verarbeiten, zeigen aber dennoch eine Reihe von Nachteilen. So enthalten Formulierungen mit Imidazolen oder Benzimidazolen oftmals Ameisensäure und ggf. andere organische Säuren, die unangenehm riechen, ätzend sind und toxikologische Nachteile haben. Zudem ist die thermische Stabilität niedrig.

Bei der Herstellung von Leiterplatten beschichtet man Kupfer zum Schutz vor Korrosion daher oft mit anderen Metallen, wie z.B. Gold, Silber oder Zinn, um die Lötfähigkeit der Kupferkontakte und der verkupferten Bohrungen zu erhalten, die durch Oxidation innerhalb kürzester Zeit verloren geht.

Eine Übersicht über gebräuchliche lötfähige Endoberflächen und deren technische, ökonomische, ökologische und toxikologische Vor- und Nachteile sind in "Alternative Technologies for Surface Finishing - Cleaner Technology for Printed Wired Board Manufacturers", EPA, Office of Pollution Prevention and Toxics, Juni 2001, EPA 744-R-01-001, offenbart.

Metallische Beschichtungen sind im allgemeinen für Leiterplatten gut geeignet, weisen jedoch ebenfalls eine Reihe von Nachteilen auf. Beschichtungen mit Gold sind nicht nur auf Grund des hohen Goldpreises teuer, sondern erfordern darüber hinaus spezielle Verfahren zum Aufbringen der Goldschicht. Beispielsweise kann Gold chemisch nicht in sogenannten Horizontalanlagen sondern nur in Vertikalanlagen aufgebracht werden, was zusätzlich hohe Verfahrenskosten verursacht.

Das Aufbringen von Silber ist schlecht reproduzierbar, und die erforderlichen Anlagen sind schwer einzustellen.

Zinn ist zwar insbesondere dann, wenn es mit Hilfe eines Organischen Metalls aufgebracht wird, wie beispielsweise bei dem ORMECON CSN-Verfahren der Ormecon GmbH, in technischer und ökonomischer Sicht zufriedenstellend, allerdings erfordert seine Abscheidung in der Regel mehrere Minuten, was entsprechend groß dimensionierte Anlagen erforderlich macht, um einen hohen Durchsatz zu gewährleisten.

Aus der EP 0 807 190 B1 ist ein Verfahren zur Herstellung metallisierter Werkstoffe bekannt, bei dem der zu metallisierende Werkstoff zunächst mit einem intrinsisch leitfähigen Polymer beschichtet, das intrinsisch leitfähige Polymer dann durch Reduktion aktiviert und schließlich das Metall in nicht elektrochemischer Weise aufgebracht wird, indem der beschichtete Werkstoff mit einer Lösung von Ionen des Metalls in Kontakt gebracht wird. Das Verfahren eignet sich besonders zur Abscheidung von Zinn auf Kupfer aber auch zur Metallisierung von Kunststoffoberflächen.

Die EP 0 407 492 B1 offenbart ein Verfahren zur Beschichtung von Substraten mit dünnen Schichten aus intrinsisch leitfähigen Polymeren, bei dem beispielsweise Polyanilin aus einer metastabilen Dispersion stromlos auf einem Substrat abgeschieden wird. Als Substrate werden unter anderem Metalle wie Gold, Platin, Eisen, Stahl, Kupfer und Aluminium genannt. Die Schichten aus leitfähigem Polymer führen bei Metallen, die unedler als Silber sind, zur Ausbildung von Metalloxidschichten und sollen sich unter anderem zum Korrosionsschutz eignen.

Die EP 0 656 958 B1 betrifft ein Verfahren zur Herstellung korrosionsgeschützter metallischer Werkstoffe wie Eisen, Stahl, Kupfer und Aluminium, bei dem eine Schicht eines intrinsisch leitfähigen Polymers auf einen metallischen Werkstoff aufgebracht und anschließend der beschichtete Werkstoff mit sauerstoffhaltigem Wasser passiviert wird. Es wird darauf hingewiesen, daß das Aufbringen des leitfähigen Polymers allein keinen ausreichenden Korrosionsschutz gewährleistet, und der metallische Werkstoff wird daher nach der Passivierung vorzugsweise mit einem Korrosionsschutzüberzug versehen. Das leitfähige Polymer kann vor dem Aufbringen des Korrosionsschutzüberzugs wieder entfernt werden.

V. Brusic et al., "Use of Polyaniline and its Derivatives in Corrosion Protection of Copper and Silver", Journal of the Electrochemical Society, February 1997, Vol. 144, Seiten 436 bis 442 betrifft die Verwendung von Polyanilin und dessen Derivaten beim Korrosionsschutz von Kupfer und Silber. Probleme der Lötfähigkeit werden von Brusic et al. jedoch nicht erörtert. Ferner beschreiben Brusic et al. die Verwendung von Polyanilin in leitfähigem Zustand als nachteilig für den Korrosionsschutz.

US 5,922,466 betrifft die Verwendung einer Zusammensetzung, die leitfähige Metallteilchen wie Silber umhüllt von leitfähigem Polymer in einer Matrix aus wärmehärtbaren oder thermoplastischem Polymer als wesentliche Bestandteile enthält, oder auch von Polyanilin allein zum Korrosionsschutz für Metallsubstrate oder zu anderen Zwecken wie Schutz vor elektrostatischer Aufladung oder elektromagnetischer Abschirmung.

WO 99/05687 betrifft Verbindungen von intrinsisch leitfähigen Polymeren, insbesondere Polyanilinen, mit Metallen, deren Herstellung sowie deren Verwendung bei der Metallisierung von Substraten, bei der Herstellung von elektrischen Leiterplatten und beim Schutz metallischer Gegenstände vor Korrosion.

Der Erfindung liegt die Aufgabe zu Grunde, beschichtete Artikel zur Verfügung zu stellen, die eine Schicht aus Kupfer oder einer Kupferlegierung enthalten, bei denen das Kupfer oder die Kupferlegierung einerseits wirkungsvoll gegen Oxidation geschützt ist und andererseits ein Verlust der Lötfähigkeit des Kupfers oder der Kupferlegierung bei der Lagerung verhindert wird.

Diese Aufgabe wird durch einen beschichteten Artikel gemäß Anspruch 1 gelöst.

Die erfindungsgemäße Lösung ist insofern überraschend, als im Hinblick auf den Stand der Technik nicht zu erwarten war, daß die Beschichtung mit einem elektrisch leitfähigem Polymer zusammen mit Kupfer-Komplexbildnern wie hierin definiert einen wirksamen Schutz von Kupfer vor Oxidation und Korrosion erlauben würde. Erst recht war keine Verbesserung hinsichtlich der Erhaltung der Lötfähigkeit von Kupfer und Kupferlegierungen zu erwarten. Gemäß dem Stand der Technik bewirken Schichten aus leitfähigem Polymer die Ausbildung dünner Metalloxidschichten auf der Oberfläche von Metallen, die unedler als Silber sind. Die Ausbildung solcher Oxidschichten wird jedoch maßgeblich für den Verlust der Lötfähigkeit von Kupfer verantwortlich gemacht.

Die Schichtdicke der Schicht (iii) liegt vorzugsweise unterhalb von 1 µm, was der allgemeinen Erwartung widerspricht, wonach man mit dickeren Schichten einen größeren Effekt erzielen würde. Vorzugsweise beträgt die Dicke der Schicht (iii) mindestens ca. 10 nm. Besonders bevorzugt sind Schichtstärken unterhalb von 500 nm, besonders bevorzugt unterhalb von 200 nm.

Die Schicht enthält mindestens ein elektrisch leitfähiges Polymer, das vorzugsweise in Form eines Organischen Metalls eingesetzt wird. Kombinationen verschiedener Stoffe aus dieser Stoffklasse können verwendet werden. Unter Polymeren werden im Rahmen dieser Erfindung, wenn nicht anders angegeben, organische Polymere verstanden.

Unter elektrisch leitfähigen Polymeren oder leitfähigen Polymeren, die auch "intrinsisch leitfähige Polymere" genannt werden, werden Stoffe verstanden, die aus niedermolekularen Verbindungen (Monomeren) aufgebaut sind, durch Polymerisation mindestens oligomer sind, also mindestens 3 Monomereinheiten enthalten, die durch chemische Bindung verknüpft sind, im neutralen (nicht leitfähigen) Zustand ein konjugiertes π-Elektronensystem aufweisen und durch Oxidation, Reduktion oder Protonierung (was oftmals als "dotieren" bezeichnet wird) in eine ionische Form überführt werden können, die leitfähig ist. Die Leitfähigkeit beträgt mindestens 10⁻⁷ S/cm und liegt üblicherweise unter 10⁵ S/cm.

Als Dotierungsmittel werden im Falle der Dotierung durch Oxidation z.B. Jod, Peroxide, Lewis- und Protonensäuren oder im Falle der Dotierung durch Reduktion z.B. Natrium, Kalium, Calcium eingesetzt.

Leitfähige Polymere können chemisch außerordentlich unterschiedlich zusammengesetzt sein. Als Monomere haben sich z.B. Acetylen, Benzol, Napthalin, Pyrrol, Anilin, Thiophen, Phenylensulfid, peri-Naphthalin und andere, sowie deren Derivate, wie Sulfo-Anilin, Ethylendioxythiophen, Thieno-thiophen und andere, sowie deren Alkyl- oder Alkoxy-Derivate oder Derivate mit anderen Seitengruppen, wie Sulfonat-, Phenyl- und andere Seitengruppen, bewährt. Es können auch Kombinationen der oben genannten Monomere als Monomer eingesetzt werden. Dabei werden z.B. Anilin und Phenylensulfid verknüpft und diese A-B-Dimere dann als Monomere eingesetzt. Je nach Zielsetzung können z.B. Pyrrol, Thiophen oder Alkylthiophene, Ethylendioxythiophen, Thieno-thiophen, Anilin, Phenylensulfid und andere miteinander zu A-B-Strukturen verbunden und diese dann zu Oligomeren oder Polymeren umgesetzt werden.

Die meisten leitfähigen Polymere weisen einen mehr oder weniger starken Anstieg der Leitfähigkeit mit steigender Temperatur auf, was sie als nicht-metallische Leiter ausweist. Andere leitfähige Polymere zeigen zumindest in einem Temperaturbereich nahe Raumtemperatur ein metallisches Verhalten insofern, als die Leitfähigkeit mit steigender Temperatur sinkt. Eine weitere Methode, metallisches Verhalten zu erkennen, besteht in der Auftragung der sogenannten "reduzierten Aktivierungsenergie" der Leitfähigkeit gegen die Temperatur bei niedrigen Temperaturen (bis nahe 0 K). Leiter mit einem metallischen Beitrag zur Leitfähigkeit zeigen eine positive Steigung der Kurve bei niedriger Temperatur. Solche Stoffe bezeichnet man als "organische Metalle".

Organische Metalle sind an sich bekannt. Gemäß Weßling et al., Eur. Phys. J. E 2, 2000, 207-210, kann der Übergang vom Zustand eines nicht-metallischen zu einem zumindest teilweise metallischen Leiter durch einen einstufigen Reib- bzw. Dispersionsvorgang nach vollendeter Synthese des intrinsisch leitfähigen Polymers bewirkt werden, dessen verfahrenstechnische Grundlage in der EP 0 700 573 A beschrieben wird. Hierbei wird durch den Dispersionsvorgang auch die Leitfähigkeit erhöht, ohne daß die chemische Zusammensetzung des verwendeten leitfähigen Polymeren wesentlich verändert wird.

Bevorzugte intrinsisch leitfähige Polymere sind die oben genannten. Insbesondere können als Beispiele genannt werden: Polyanilin (PAni), Polythiophen (PTh), Poly(3,4-ethylendioxythiophene) (PEDT), Polydiacetylen, Polyacetylen (PAc), Polypyrrol (PPy), Polyisothianaphthen (PITN), Polyheteroarylenvinylen (PArV), wobei die Heteroarylen-Gruppe z.B. Thiophen, Furan oder Pyrrol sein kann, Poly-p-phenylen (PpP), Polyphenylensulfid (PPS), Polyperinaphthalin (PPN), Polyphthalocyanin (PPc) u.a., sowie deren Derivate (die z.B. aus mit Seitenketten oder -gruppen substituierten Monomeren gebildet werden), deren Copolymere und deren physikalische Mischungen. Besonders bevorzugt sind Polyanilin (PAni), Polythiophen (PTh), Polypyrrol (PPy), Poly(3,4-ethylendioxythiophene) (PEDT), Polythieno-thiophen (PTT) und deren Derivate sowie Mischungen davon. Am meisten bevorzugt ist Polyanilin.

Die Schicht (iii) kann Mischungen von einem oder mehreren leitfähigen Polymeren mit anderen Stoffen wie nicht elektrisch leitfähigen Komponenten enthalten. Gemäß einer bevorzugten Ausführungsform enthält die Schicht (iii) Polymerblends, also Mischungen von leitfähigem Polymer / Organischem Metall (oder einer Kombination von mehreren) mit elektrisch nicht leitfähigen Polymeren. Als nicht leitfähige Polymere eignen sich besonders wasserlösliche oder wasserdispergierbare Polymere, insbesondere Polystyrolsulfonsäure, Polyacrylate, Polyvinylbutyrate, Polyvinylpyrrolidone, Polyvinylalkohole und Mischungen davon. Leitfähige und nicht leitfähige Polymere werden vorzugsweise im Verhältnis von 1 : 1,5 bis 1 : 20 eingesetzt.

Die Schicht (iii) kann auch weitere Additive enthalten, insbesondere Viskositätsregler, Verlaufshilfen, Trocknungshilfen, Glanzverbesserer, Mattierungsmittel und Mischungen davon, vorzugsweise in einer Konzentration von 0,01 bis 5 Gew.-% Additiv bezogen auf die Masse der Schicht (iii). Die Schicht (iii) enthält vorzugsweise 5 bis 98 Gew.-%, insbesondere 15 bis 40 Gew.-% leitfähiges Polymer, bezogen auf die Masse der Schicht (iii).

Erfindungsgemäß wird eine Kombination des / der leitfähigen Polymeren / Organischen Metalle mit Komplex-Bildnern verwendet, die in Lage sind, Kupfer zu komplexieren, wobei diese ausgewählt sind aus Imidazolen, Benzimidazolen oder vergleichbare Komplexbildnern, wie Benzotriazolen, Thioharnstoff, Imidazol-2-thionen, und Mischungen davon, die sich durch eine relativ gute thermische Stabilität auszeichnen.

Als Basisschicht (i) sind alle in der Leiterplattentechnik eingesetzten Materialien geeignet, insbesondere Epoxide und Epoxidcomposite, Teflon, Cyanatester, Keramik, Cellulose und Cellulosecomposite, wie beispielsweise Pappe, auf diesen Stoffen basierende Materialien sowie flexible Basisschichten z.B. auf Basis von Polyimid. Die Basisschicht weist vorzugsweise eine Schichtdicke von 0,1 bis 3 mm auf.

Die Kupferschicht oder Kupferlegierungsschicht (ii) hat vorzugsweise eine Dicke von 5 bis 210 µm, insbesondere 15 bis 35 µm.

Zwischen der Schicht (ii) und der Schicht (iii) kann eine weitere Metall- oder Legierungsschicht (iv) angeordnet werden. Die Schicht (iv) enthält vorzugsweise Silber, Zinn, Gold, Palladium oder Platin. Gemäß einer bevorzugten Ausführungsform enthält die Schicht (iv) überwiegend, d.h. zu mehr als 50 Gew.-% bezogen auf die Masse der Schicht (iv) eines oder mehrere der genannten Metalle. Die genannten Metalle können insbesondere als Legierung mit Kupfer vorliegen. Gemäß einer anderen bevorzugten Ausführungsform besteht die Schicht (iv) ausschließlich aus den genannten Metallen, entweder in reiner Form oder in Form einer Legierung. Die Schicht (iv) weist vorzugsweise eine Schichtdicke von 10 bis 800 nm auf. Neben dem Metall oder der Legierung kann die Schicht (iv) organische Komponenten enthalten, in einer Konzentration von vorzugsweise 1 bis 80 Gew.-% bezogen auf die Gesamtmasse der Schicht (iv) (Metallanteil 20 bis 99 Gew.-%). Bevorzugte organische Komponenten sind leitfähige Polymere bzw. organische Metalle, oder organische Kupferkomplexbildner wie Thioharnstoff, Benzotriazole.

Die erfindungsgemäßen Artikel eignen sich besonders zur Herstellung von Leiterplatten, vorzugsweise handelt es sich bei den Artikeln um Leiterplatten, die auch als Platinen bezeichnet werden. Hierbei handelt es sich um der Montage elektrischer Bauelemente dienende, dünne Platten, die Löcher aufweisen können. Die Löcher dienen beispielsweise zur Verbindung von Ober- und Unterseite der Platten, zur Verfügungstellung von Lot oder zur Aufnahme der Anschlüsse von Bauelementen zur weiteren Verlötung.

Zur Herstellung der erfindungsgemäßen beschichteten Artikel und insbesondere von Leiterplatten
(1) bringt man auf die Oberfläche einer Basisschicht eine Schicht aus Kupfer oder einer kupferhaltigen Legierung auf;
(2) strukturiert die in Schritt (1) hergestellte Schicht; und
(3) bringt auf die strukturierte Kupfer- oder Kupferlegierungsschicht eine Schicht auf, die mindestens ein elektrisch leitfähiges Polymer und mindestens einen Kupfer-Komplexbildner wie verstehend definiert enthält.

Gemäß einer bevorzugten Ausführungsform des Verfahrens wird die Kupfer- oder Kupferlegierungsschicht (ii) im Anschluß an Schritt (1) entfettet und gereinigt. Hierzu werden die Artikel vorzugsweise mit handelsüblichen, sauren oder basischen Reiniger behandelt. Bevorzugt sind Reiniger auf der Basis von Schwefelsäure und Zitronensäure, wie z.B. der Reiniger ACL 7001 der Ormecon GmbH. Die Artikel werden vorzugsweise für etwa 2 Minuten bei 45 °C in dem Reinigungsbad belassen und anschließend mit Wasser gewaschen.

Außerdem ist es bevorzugt, die Kupfer- oder Kupferlegierungsschicht (ii) im Anschluß an Schritt (1) oder nach der Reinigung oxidativ vorzubehandeln, beispielsweise durch Ätzen der Oberfläche mit H₂O₂ oder anorganischen Peroxiden. Geeignete Ätzlösungen sind kommerziell erhältlich, wie beispielsweise die wasserstoffperoxidhaltige Lösung Etch 7000 der Ormecon GmbH. Die Artikel werden vorzugsweise für etwa 2 Minuten bei 30 °C in der Ätzlösung belassen.

Die in Schritt (1) hergestellte Schicht wird vorzugsweise mit lithographischen oder Ätzprozessen strukturiert, womit die Leiterbahnstruktur erzeugt wird. Die Schritte (1) und (2) können heute auch durch das direkte Aufbringen einer strukturierten Cu-Leiterbahn oder ähnliche Verfahren ersetzt werden.

Im Anschluß an Schritt (2) werden ggf. Bohrungen ("Löcher") erzeugt, die anschließend verkupfert werden.

Die Durchführung der einzelnen Schritte des obigen Verfahrens ist dem Fachmann an sich bekannt. Vorzugsweise wird die Schicht (iii) auf den Artikel aufgebracht, indem dieser, nach dem Spülen mit Wasser, mit einer Dispersion des oder der leitfähigen Polymeren bzw. Organischen Metalle in einem bei Raumtemperatur flüssigen Dispersionsmittel behandelt wird, beispielsweise durch Eintauchen des Artikels in die Dispersion oder durch Aufbringen derselben auf den Artikel. Das oder die elektrisch leitfähigen Polymere sind vorzugsweise in kolloidaler Form in dem Dispersionsmedium enthalten. Vorzugsweise wird der Artikel für etwa 1 Minute bei Raumtemperatur mit der Dispersion kontaktiert. Zusätzliche Komponenten, wie nicht elektrisch leitfähige Polymere und Additive können in dem Dispersionsmedium gelöst sein oder ebenfalls kolloidal darin vorliegen. Als Dispersionsmedien eignen sich organische Lösemittel, vorzugsweise mit Wasser mischbare organische Lösemittel, Wasser und Mischungen davon. Bevorzugte mit Wasser mischbare Lösemittel sind Alkohole, insbesondere Alkohole mit einem Siedepunkt von mehr als 100 °C und vorzugsweise unter 250 °C. Nach dem Aufbringen der Dispersion auf den Artikel wird dieser schonend getrocknet und ggf. weitere Dispersion aufgebracht, bis die gewünschte Schichtdicke erreicht ist. Die Herstellung und Anwendung zur Beschichtung geeigneter Dispersionen ist aus dem Stand der Technik bekannt, vgl. beispielsweise EP 0 407 492 B1.

Als Dispersionsmedium sind Wasser und wäßrige Lösemittel bevorzugt. Diese sind nicht nur im Hinblick auf Emissionen und die Nicht-Benetzung des Lötstoplacks vorteilhaft, es wurde auch gefunden, daß Wasser und wäßrige Lösungsmittel bessere Ergebnisse erbringen. Dies war insofern überraschend, als Oxidationsvorgänge auf Kupfer in wäßrigem Milieu besonders schnell ablaufen. Mit Lötstoplack werden die Bereiche der Leiterplatte abgedeckt, die beim Bestückungsprozeß nicht vom Lot benetzt werden dürfen. Der Lötstoplack sollte nicht mit dem leitfähigem Polymer benetzt werden, da dieses sonst Kurzschlüsse zwischen den Kontaktpunkten bewirken würde.

Vorzugsweise werden Dispersionen verwendetet, die keine Ameisensäure enthalten, andere Säuren und/oder Puffer können jedoch in den Dispersionen enthalten sein.

Besonders geeignete Dispersionen sind kommerziell erhältlich, beispielsweise Dispersionen auf der Basis von Polyanilin, wie Dispersionen von Polyanilin-Polystyrolsulfonsäure-Blends in Wasser, z.B. das Produkt D 1012 der Ormecon GmbH, und Dispersionen von Polyanilin-Polyvinylpyrrolidon in Wasser, z.B. das Produkt D 1021 der Ormecon GmbH.

Es ist ebenfalls möglich, daß anstelle der reinen intrinsisch leitfähigen Polymere Polymerblends mit einem Gehalt von vorzugsweise 0,1 bis 45 Gew.-% und besonders bevorzugt 5 bis 35 Gew.-% intrinsisch leitfähigem Polymer eingesetzt werden. Neben intrinsisch leitfähigem Polymer enthalten diese Polymerblends weitere Polymere, Copolymere oder Polymermischungen, wie z.B. Polyamide, Polyester, Polyether, wie Polyethylenoxide, Copolymer-Latices auf wäßriger Basis, wie z.B. Vinylacetatbutylacrylat, oder andere Copolymer-Latices, und/oder Polyvinylalkohole. Besonders bevorzugte weitere Polymere sind Polyamide.

Die erfindungsgemäßen beschichteten Artikel zeichnen sich insbesondere dadurch aus, daß sie sich auch nach längerer Lagerung nicht nur gut löten lassen sondern auch mehrfach lötfähig sind, d.h. in mehrstufigen Lötprozessen, sogenannten reflow-Prozessen, eingesetzt werden können. In dieser Hinsicht konnte durch die erfindungsgemäßen beschichteten Artikel eine deutliche Annäherung der Löt- und Alterungseigenschaften an Leiterplatten mit metallischen Endoberflächen erzielt werden, die bis zu 12 Monate gelagert werden können, ohne ihre Lötfähigkeit einzubüßen, und die nach der Lagerung mehrfach gelötet werden können. Im Gegensatz dazu sind herkömmliche Leiterplatten, die allein mit Kupfer komplexierenden Mitteln zur Aufrechterhaltung der Lötfähigkeit behandelt wurden, sogenannte "OSP" (Organic Solderability Preservative), in der Regel schon nach einer Lagerung von nur 3 bis 6 Monaten nicht mehr lötfähig, geschweige denn für Mehrfach-Reflow-Prozesse geeignet. Die Leiterplatten werden als für Reflow-Prozesse besonders geeignet angesehen, wenn der Lötwinkel kleiner als 90°, vorzugsweise 60° oder kleiner ist. Als OSPs werden meist saure, wäßrige Formulierungen auf der Basis von z.B. Benzotriazolen eingesetzt, die Ameisensäure und/oder Essigsäure enthalten.

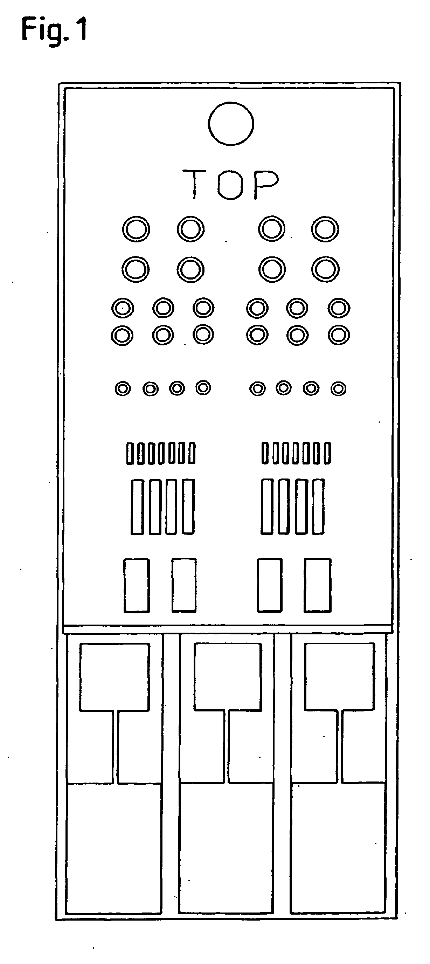

Im Folgenden wird die Erfindung anhand einer Figur und von nicht einschränkenden Ausführungsbeispielen weiter erläutern, wobei Figur 1 eine Leiterplatte mit einem Testdesign zeigt.

### Ausführungsbeispiele

Nur Beispiel 2 ist erfindungsgemäß.

### Beispiele 1 bis 2: Herstellung beschichteter Leiterplatten

Leiterplatten aus Epoxidharz-Composite wurden unter Verwendung eines handelsüblichen Reinigers auf der Basis von Schwefelsäure und Zitronensäure (ACL 7001, Ormecon GmbH) in einem Reinigungsbad für 2 Minuten bei 45 °C gereinigt und entfettet. Die verwendeten Leiterplatten hatten ein Testdesign (siehe Figur 1), das mit Prüfinstituten und Leiterplattenherstellern abgestimmt und realen Leiterplattenstrukturen nachempfunden ist. Diese Platten erlauben die Messung und Beurteilung der Lötfähigkeit. Anschließend wurden die Leiterplatten bei Raumtemperatur mit Leitungswasser gespült und danach für 2 Minuten bei 30 °C mit einer H₂O₂ enthaltenden Ätzlösung (Etch 7000, Ormecon GmbH) behandelt. Nach dem Ätzen wurden die Platten erneut bei Raumtemperatur mit Leitungswasser gespült und dann mit den in Tabelle 1 aufgeführten leitfähigen organischen Polymeren beschichtet. Hierzu wurden die Platten bei Raumtemperatur für 1 Minute in eine wäßrige Dispersion des jeweiligen Polymers eingetaucht. Danach wurden die Leiterplatten bei 45 bis 75 °C getrocknet.

**Tabelle 1**

| **Zur Beschichtung der Platten eingesetzte Polymere** | |
|---|---|
| **Beispiel** | **leitfähiges Polymer** |
| 1 | Polyanilin-Polypyrrolidon-Blend¹⁾ |
| 2 | Polyanilin-Polypyrrolidon-Blend¹⁾ mit Zusatz einer Kupferkomplexbildners²⁾ |

| | |
|---|---|
| ¹⁾ D 1021, Ormecon GmbH | |
| ²⁾ Benzotriazol (2 MZA, Fa. Shikoku) | |

Die Dispersion 1 enthielt 1,25 Gew.-% und die Dispersion 2 1,25 Gew.-% Festkörper, wobei in Dispersion 2 der Festkörperanteil 6 Gew.-% des Kupferkomplexbildners bezogen auf die Masse des Festkörperanteils enthielt.

### Beispiele 3 und 4: Herstellung beschichteter Leiterplatten (Vergleich)

Analog zu den Beispielen 1 bis 2 wurden Leiterplatten gemäß den jeweiligen Anwendungsvorschriften mit handelsüblichen Mittel auf der Basis von Benzotriazol beschichtet (Glicoat Tough Ace F2 (LX) ; Firma Shikoku, Japan, Beispiel 3 und Entek Plus Cu 106 A, Firma Enthone OMI, Niederlande, Beispiel 4).

### Beispiel 5: Lötwinkelmessung

Ein Teil der in den Beispielen 1 bis 4 hergestellten Leiterplatten wurde einem beschleunigtem Alterungsverfahren unterworfen, indem einige Platten für 1 Stunde bei 100 °C und andere für 4 Stunden bei 144 °C gelagert wurden. Von den frisch hergestellten und den bei 100 °C bzw. 144 °C gealterten Platten wurde mit einem handelsüblichen Meniscographen (Typ ST 60, Fa. Metronelec) der Lötwinkel (Benetzungswinkel; gemäß der Norm NF A 89 400 P bzw. ANSI-J-STD 003 I.E.C. 68-2-69) ermittelt. Das Gerät mißt die Benetzungskraft über die Zeit und rechnet diese nach üblichen Verfahren in Lötwinkel um (siehe Handbuch). Der Lötwinkel wurde jeweils ohne, nach zwei 2 und nach 3 reflow-Zyklen gemessen. Die reflow-Zyklen dienen der Simulation wiederholter Lötvorgänge und wurden in einem Hot-Air/Quartz Reflow Oven HA 06 (Fa. C.I.F./Athelec, Frankreich) durchgeführt, der Mehrfachlöten mit Temperaturprofilen simuliert.

Die Ergebnisse der Lötwinkelmessungen sind in Tabelle 2 gezeigt.

**Tabelle 2**

| **Ergebnisse der Lötwinkelmessung¹⁾** | | | | | | | | | |
|---|---|---|---|---|---|---|---|---|---|
| **Bsp.** | **Frisch hergestellte Platten** | | | **1 h Alterung bei 100 °C** | | | **4 h Alterung bei 155 °C** | | |
| | **1. LV** | **2. LV** | **3.LV** | **1. LV** | **2. LV** | **3. LV** | **1. LV** | **2. LV** | **3. LV** |
| **1** | 10 | 61 | 61 | 22 | 68 | 76 | 49 | 74 | 77 |
| **2** | 20 | 65 | 82 | 24 | 50 | 73 | 33 | 70 | 76 |
| **3*** | 29 | 68 | 99 | 30 | 39 | 91 | 70 | 102 | 93 |
| **4*** | 21 | 51 | 84 | 21 | 50 | 75 | 52 | 83 | 96 |

| | | | | | | | | | |
|---|---|---|---|---|---|---|---|---|---|
| ¹⁾ Lötwinkel in ° nach 2 Sekunden, gemessen mit bleihaltigem Lot (Sn/Pb = 60/40) | | | | | | | | | |
| LV Lötvorgang | | | | | | | | | |
| * Vergleichsversuch | | | | | | | | | |

Die Ergebnisse in Tabelle 2 zeigen, daß die Lötwinkel bei zunehmender Alterung und insbesondere bei wiederholtem Löten ansteigen. Während die Lötwinkel bei ersten Lötvorgang selbst nach der zweiten Alterungsstufe für die erfindungsgemäßen Leiterplatten und die Leiterplatten nach dem Stand der Technik noch in einer vergleichbaren Größenordnung liegen, wird bei den Vergleichsplatten beim zweiten Lötvorgang schon eine deutliche Zunahme des Lötwinkels beobachtet, der zum Teil schon über dem kritischen Wert von 90° liegt (Beispiel 3). Beim dritten Lötvorgang liegen die Lötwinkel beider Vergleichsplatten mit 93° und 96° oberhalb von 90°, was eine schlechte Benetzung der Oberfläche und eine ungenügende Lötfähigkeit anzeigt. Im Gegensatz dazu ist bei den erfindungsgemäßen Platten nach vierstündiger Lagerung bei 155 °C keine Zunahme des Lötwinkels beim Übergang vom zweiten zum dritten Lötvorgang feststellbar, so daß diese Platten auch im gealterten Zustand ohne Einschränkung für wiederholte Lötvorgänge geeignet sind.

### Beispiel 6: Herstellung beschichteter Leiterplatten

Cu-Leiterplatten aus Epoxidharz-Composite mit einem Testdesign (siehe Figur 1) wurden entsprechend Beispiel 1 unter Verwendung eines handelsüblichen Reinigers auf der Basis von Schwefelsäure und Zitronensäure (ACL 7001, Ormecon GmbH) in einem Reinigungsbad für 2 Minuten bei 45 °C gereinigt und entfettet. Anschließend wurden die Leiterplatten bei Raumtemperatur dreimal mit Leitungswasser gespült (< 1 min) und danach für 2 Minuten bei 35 °C mit einer H₂O₂ enthaltenden Ätzlösung (Micro Etch MET 7000, Konzentration: 2 Vol.-%, Ormecon GmbH) behandelt. Nach dem Ätzen wurden die Platten erneut bei Raumtemperatur dreimal mit Leitungswasser gespült (< 1 min) und dann mit wäßrigen Dispersion von elektrisch leitfähigem Polyanilin (PA, Konzentration: 0,5 % organisches Metall) beschichtet. Hierzu wurden die Platten bei 35 °C für etwa 3 Minute in die Dispersion eingetaucht. Danach wurden die Leiterplatten dreimal mit entionisiertem Wasser (50 °C) gespült (< 0,5 min) und dann gründlich getrocknet. Die Leiterplatten wiesen nach der Behandlung eine dünne, gleichmäßige und planare, klare Beschichtung mit einer Dicke von 100 bis 200 nm auf. Anschließend wurde auf die in Beispiel 5 beschriebene Weise der Lötwinkel ermittelt. Die Ergebnisse sind in Tabelle 3 gezeigt. Als Vergleich dienten Leiterplatten, die auf herkömmliche Weise mit Zinn (Sn) beschichtet worden waren.

Die Ergebnisse zeigen, daß die Lötfähigkeit der erfindungsgemäß beschichteten Platten mit der von zinnbeschichteten Platten vergleichbar ist.

**Tabelle 3**

| **Ergebnisse der Lötwinkelmessung¹⁾** | | | | |
|---|---|---|---|---|
| **Beschichtung** | **2 mal reflow** | **3 mal reflow** | **1 h Alterung bei 100 °C** | **4 h Alterung bei 155 °C** |
| **PA²⁾** | 35° | 45° | 30° | 40° |
| **Sn³⁾*** | 29° | 42° | - | 18° |

| | | | | |
|---|---|---|---|---|
| ¹⁾ Lötwinkel gemessen mit bleihaltigem Lot (Sn/Pb 60/40) | | | | |
| ²⁾ elektrisch leitendes Polyanilin | | | | |
| ³⁾ Zinnbeschichtung | | | | |
| * Vergleichsversuch | | | | |

## Patentansprüche

1. Beschichteter Artikel, der
(i) mindestens eine nicht elektrisch leitende Basisschicht,
(ii) mindestens eine Schicht aus Kupfer und/oder einer Kupferlegierung, und
(iii) eine Schicht, die mindestens ein elektrisch leitfähiges Polymer enthält,
aufweist, **dadurch gekennzeichnet, dass** die Kupfer- oder Kupferlegierungsschicht (ii) zwischen der Basisschicht (i) und der das leitfähige Polymer enthaltenden Schicht (iii) angeordnet ist, wobei die Schicht (ii) auf der Oberfläche der Basisschicht aufgebracht ist und die Schicht (iii) ferner mindestens einen Komplexbildner enthält, der in der Lage ist, Kupfer zu komplexieren, wobei der Komplexbildner aus Benzimidazolen, Imidazolen, Benzotriazolen, Thioharnstoff, Imidazol-2-thionen und Mischungen davon ausgewählt ist.

2. Beschichteter Artikel nach Anspruch 1, bei dem die Schicht (iii) eine Schichtdicke von 10 nm bis 1 µm aufweist.

3. Beschichteter Artikel nach Anspruch 2, bei dem die Schicht (iii) eine Schichtdicke von weniger als 500 nm aufweist.

4. Beschichteter Artikel nach Anspruch 3, bei dem die Schicht. (iii) eine Schichtdicke von weniger als 200 nm aufweist.

5. Beschichteter Artikel nach einem der vorhergehenden Ansprüche, bei dem die Schicht (iii) mindestens eine nicht elektrisch leitende Komponente und mindestens ein elektrisch leitfähiges Polymer enthält.

6. Beschichteter Artikel nach Anspruch 5, bei dem die Schicht (iii) 5 Gew.-% bis 98 Gew.-% elektrisch leitfähiges Polymer bezogen auf die Masse der Schicht (iii) enthält.

7. Beschichteter Artikel nach Anspruch 5 oder 6, bei dem die nicht elektrisch leitende Komponente ein Polymer ist.

8. Beschichteter Artikel nach einem der vorhergehenden Ansprüche, bei dem das elektrisch leitende Polymer aus Polyanilin (PAni), Polythiophen (PTh), Polypyrrol (PPy), Poly(3,4-ethylendioxythiophene) (PEDT), Polythieno-thiophen (PTT), deren Derivaten und Mischungen davon ausgewählt ist.

9. Beschichteter Artikel nach einem der vorhergehenden Ansprüche, bei dem als elektrisch leitendes Polymer ein Polymerblend mit einem Gehalt an mindestens einem elektrisch leitenden Polymer eingesetzt wird.

10. Beschichteter Artikel nach einem der vorangehenden Ansprüche, bei dem die Basisschicht (i) Epoxid, Epoxidcomposit, Teflon, Cyanatester, Keramik, Cellulose, Cellulosecomposit, Pappe und/oder Polyimid enthält.

11. Beschichteter Artikel nach einem der vorhergehenden Ansprüche, bei dem die Basisschicht (i) eine Schichtdicke von 0,1 bis 3 mm aufweist.

12. Beschichteter Artikel nach einem der vorhergehenden Ansprüche, bei dem die Schicht (ii) eine Schichtdicke von 5 bis 210 µm aufweist.

13. Beschichteter Artikel nach einem der vorhergehenden Ansprüche, der eine weitere Metall- oder Legierungsschicht (iv) enthält, die zwischen der Schicht (ii) und der Schicht (iii) angeordnet ist.

14. Beschichteter Artikel nach Anspruch 13, bei dem die Schicht (iv) Silber, Zinn, Gold, Palladium oder Platin enthält.

15. Beschichteter Artikel nach Anspruch 13 oder 14, bei dem die Schicht (iv) eine Schichtdicke von 10 bis 800 nm aufweist.

16. Beschichteter Artikel nach einem der vorhergehenden Ansprüche in Form einer Leiterplatte.

17. Verfahren zur Herstellung eines beschichteten Artikels gemäß Anspruch 16, bei dem
(1) man auf die Oberfläche einer Basisschicht eine Schicht aus Kupfer oder einer kupferhaltigen Legierung aufbringt,
(2) man die in Schritt (1) hergestellte Schicht strukturiert; und
(3) man auf die strukturierte Kupfer- oder Kupferlegierungsschicht eine Schicht aufbringt, die mindestens ein elektrisch leitfähiges Polymer und mindestens einen Komplexbildner enthält, der in der Lage ist, Kupfer zu komplexieren, wobei wobei der Komplexbildner aus Benzimidazolen, Imidazolen, Benzotriazolen, Thioharnstoff, Imidazol-2-thionen und Mischungen davon ausgewählt ist.

18. Verfahren nach Anspruch 17, bei dem man die Kupfer- oder Kupferlegierungsschicht (ii) im Anschluß an Schritt (1) einer Reinigung unterwirft.

19. Verfahren nach Anspruch 17 oder 18, bei dem man die Kupfer- oder Kupferlegierungsschicht (ii) im Anschluß an Schritt (1) oder nach der Reinigung einer oxidativen Vorbehandlung unterwirft.

20. Verwendung einer Dispersion, die ein bei Raumtemperatur flüssiges Dispersionsmedium und ein elektrisch leitfähiges Polymer sowie einen Komplexbildner enthält, der in der Lage ist, Kupfer zu komplexieren, wobei der Komplexbildner aus Benzimidazolen, Imidazolen, Benzotriazolen, Thioharnstoff, Imidazol-2-thionen und Mischungen davon ausgewählt ist, zur Verhinderung der Korrosion und/oder der Verhinderung eines Verlustes der Lötfähigkeit von Leiterplatten.

21. Verwendung nach Anspruch 20, bei der die Dispersion mindesten eine weitere Komponente enthält, die aus nicht elektrisch leitfähigen Komponenten, Viskositätsreglern, Verlaufshilfen, Trocknungshilfen, Glanzverbesserern, Mattierungsmitteln und Mischungen davon ausgewählt ist.

22. Verwendung nach Anspruch 20 oder 21, bei der das Dispersionsmedium Wasser, ein mit Wasser mischbares organisches Lösemittel oder eine Mischung davon enthält.

## Claims

1. Coated article, which has
(i) at least one electrically non-conductive base layer,
(ii) at least one layer of copper and/or a copper alloy, and
(iii) a layer which contains at least one electrically conductive polymer,
**characterized in that** the copper or copper alloy layer (ii) is positioned between the base layer (i) and the layer (iii) containing the conductive polymer, wherein the layer (ii) is applied on the surface of the base layer and the layer (iii) further contains at least one complexing agent which is capable of complexing copper, wherein the complexing agent is selected from benzimidazoles, imidazoles, benzotriazoles, thiourea, imidazole-2-thiones and mixtures thereof.

2. Coated article according to claim 1, wherein the layer (iii) has a layer thickness of 10 nm to 1 µm.

3. Coated article according to claim 2, wherein the layer (iii) has a layer thickness of less than 500 nm.

4. Coated article according to claim 3, wherein the layer (iii) has a layer thickness of less than 200 nm.

5. Coated article according to one of the previous claims, wherein the layer (iii) contains at least one electrically non-conductive component and at least one electrically conductive polymer.

6. Coated article according to claim 5, wherein the layer (iii) contains 5 wt. % to 98 wt. % of electrically conductive polymer, based on the mass of the layer (iii).

7. Coated article according to claim 5 or 6, wherein the electrically non-conductive component is a polymer.

8. Coated article according to one of the previous claims, wherein the electrically conductive polymer is selected from polyaniline (PAni), polythiophene (PTh), polypyrrole (PPy), poly(3,4-ethylenedioxythiophenes) (PEDT), polythienothiophene (PTT), derivatives thereof and mixtures thereof.

9. Coated article according to one of the previous claims, wherein a polymer blend with a content of at least one electrically conductive polymer is used as the electrically conductive polymer.

10. Coated article according to one of the previous claims, wherein the base layer (i) contains epoxide, epoxide composite, Teflon, cyanate ester, ceramic, cellulose, cellulose composite, cardboard and/or polyimide.

11. Coated article according to one of the previous claims, wherein the base layer (i) has a layer thickness of 0.1 to 3 mm.

12. Coated article according to one of the previous claims, wherein the layer (ii) has a layer thickness of 5 to 210 µm.

13. Coated article according to one of the previous claims, which contains a further metal or alloy layer (iv), which is positioned between the layer (ii) and the layer (iii).

14. Coated article according to claim 13, wherein the layer (iv) contains silver, tin, gold, palladium or platinum.

15. Coated article according to claim 13 or 14, wherein the layer (iv) has a layer thickness of 10 to 800 nm.

16. Coated article according to one of the previous claims in the form of a printed circuit board.

17. Process for the production of a coated article according to claim 16, wherein
(1) a layer of copper or of a copper-containing alloy is applied onto the surface of a base layer,
(2) the layer produced in step (1) is structured; and
(3) a layer, which contains at least one electrically conductive polymer and at least one complexing agent which is capable of complexing copper wherein the complexing agent is selected from benzimidazoles, imidazoles, benzotriazoles, thiourea, imidazole-2-thiones and mixtures thereof is applied onto the structured copper or copper alloy layer.

18. Process according to claim 17, wherein the copper or copper alloy layer (ii) is subjected to cleaning following step (1).

19. Process according to claim 17 or 18, wherein the copper or copper alloy layer (ii) is subjected to an oxidative pretreatment following step (1) or after the cleaning.

20. Use of a dispersion which contains a dispersion medium which is liquid at room temperature and contains an electrically conductive polymer as well as a complexing agent which is capable of complexing copper, wherein the complexing agent is selected from benzimidazoles, imidazoles, benzotriazoles, thiourea, imidazole-2-thiones and mixtures thereof, for the prevention of the corrosion and/or the prevention of a loss of the solderability of printed circuit boards.

21. Use according to claim 20, wherein the dispersion contains at least one further component, which is selected from electrically non-conductive components, complexing agents, viscosity modifiers, flow aids, drying aids, gloss improvers, flatting agents and mixtures thereof.

22. Use according to claim 20 or 21, wherein the dispersion medium contains water, an organic solvent miscible with water or a mixture thereof.

## Revendications

1. Article revêtu comprenant :
(i) au moins une couche de base non conductrice électriquement,
(ii) au moins une couche en cuivre et/ou en un alliage de cuivre, et
(iii) une couche comprenant au moins un polymère électriquement conducteur,
**caractérisé en ce que** la couche en cuivre ou alliage de cuivre (ii) est disposée entre la couche de base (i) et la couche comprenant le polymère conducteur (iii), la couche (ii) étant disposée sur la surface de la couche de base et la couche (iii) comprenant en outre un agent complexant, qui est en mesure de complexer le cuivre, l'agent complexant étant choisi parmi les benzimidazoles, les imidazoles, les benzotriazoles, la thiourée, les imidazole-2-thiones, et des mélanges de ceux-ci.

2. Article revêtu selon la revendication 1, dans lequel la couche (iii) présente une épaisseur de couche de 10 nm à 1 µm.

3. Article revêtu selon la revendication 2, dans lequel la couche (iii) présente une épaisseur de couche inférieure à 500 nm.

4. Article revêtu selon la revendication 3, dans lequel la couche (iii) présente une épaisseur de couche inférieure à 200 nm.

5. Article revêtu selon une des revendications précédentes, dans lequel la couche (iii) comprend au moins un composant non conducteur électriquement et au moins un polymère conducteur électriquement.

6. Article revêtu selon la revendication 5, dans lequel la couche (iii) comprend de 5 % en poids à 98 % en poids de polymère électriquement conducteur par rapport à la masse de la couche (iii).

7. Article revêtu selon la revendication 5 ou 6, dans lequel le composant non conducteur électriquement est un polymère.

8. Article revêtu selon une des revendications précédentes, dans lequel le polymère électriquement conducteur est choisi parmi la polyaniline (PAni), le polythiophène (PTh), le polypyrrole (PPy), le poly(3,4-éthylènedioxythiophène) (PEDT), le polythiénothiophène (PTT), leurs dérivés et des mélanges de ceux-ci.

9. Article revêtu selon une des revendications précédentes, dans lequel, à titre de polymère électriquement conducteur, un mélange polymère ayant une teneur en au moins un polymère électriquement conducteur est inclus.

10. Article revêtu selon une des revendications précédentes, dans lequel la couche de base (i) comprend de l'époxy, un composite époxy, du Téflon, de l'ester de cyanate, de la céramique, de la cellulose, un composite de cellulose, du carton et/ou du polyimide.

11. Article revêtu selon une des revendications précédentes, dans lequel la couche de base (i) présente une épaisseur de couche de 0,1 à 3 mm.

12. Article revêtu selon une des revendications précédentes, dans lequel la couche (ii) présente une épaisseur de couche de 5 à 210 µm.

13. Article revêtu selon une des revendications précédentes, qui comprend une autre couche de métal ou d'alliage (iv) qui se situe entre la couche (ii) et la couche (iii).

14. Article revêtu selon la revendication 3, dans lequel la couche (iv) comprend de l'argent, de l'étain, de l'or, du palladium ou du platine.

15. Article revêtu selon la revendication 13 ou 16, dans lequel la couche (iv) présente une épaisseur de couche de 10 à 800 nm.

16. Article revêtu selon une des revendications précédentes, sous forme d'une carte de circuit imprimé.

17. Procédé de fabrication d'un article revêtu selon la revendication 16, dans lequel :
(1) on dépose, sur la surface d'une couche de base, une couche en cuivre ou en un alliage contenant du cuivre,
(2) on structure la couche fabriquée à l'étape (1) ; et
(3) on dépose, sur la couche en cuivre ou en alliage de cuivre structurée, une couche qui comprend au moins un polymère électriquement conducteur et au moins un agent complexant qui est en mesure de complexer le cuivre, l'agent complexant étant choisi parmi les benzimidazoles, les imidazoles, les benzotriazoles, la thiourée, les imidazole-2-thiones, et des mélanges de ceux-ci.

18. Procédé selon la revendication 17, dans lequel on soumet la couche en cuivre ou en alliage de cuivre (ii) à une purification à la suite de l'étape (1).

19. Procédé selon la revendication 17 ou 18, dans lequel on soumet la couche en cuivre ou en alliage de cuivre (ii) à un prétraitement oxydant à la suite de l'étape (1) ou après la purification.

20. Utilisation d'une dispersion qui comprend un milieu de dispersion liquide à température ambiante et un polymère électriquement conducteur ainsi qu'un agent complexant, qui est en mesure de complexer le cuivre, l'agent complexant étant choisi parmi les benzimidazoles, les imidazoles, les benzotriazoles, la thiourée, les imidazole-2-thiones, et des mélanges de ceux-ci, pour empêcher la corrosion et/ou empêcher une perte de l'aptitude au brasage des cartes de circuit imprimé.

21. Utilisation selon la revendication 20, dans laquelle la dispersion comprend au moins un autre composant qui est choisi parmi les composants électriquement non conducteurs, les régulateurs de viscosité, les agents d'écoulement, les auxiliaires de séchage, les améliorants de brillance, les agents matifiants et des mélanges de ceux-ci.

22. Utilisation selon la revendication 20 ou 21, dans laquelle le milieu de dispersion contient de l'eau, un solvant organique miscible avec l'eau ou un mélange de ceux-ci.
